(19) Europäisches Patentamt
European Patent Office
Office européen des brevets

(11) **EP 2 765 705 B1**

(12) **FASCICULE DE BREVET EUROPEEN**

(45) Date de publication et mention
de la délivrance du brevet:
**19.08.2015  Bulletin 2015/34**

(21) Numéro de dépôt: **13154432.2**

(22) Date de dépôt: **07.02.2013**

(51) Int Cl.:
*H03H 9/02* *(2006.01)*     *G04B 17/06* *(2006.01)*
*G04B 17/22* *(2006.01)*    *G04C 3/00* *(2006.01)*
*G04F 5/06* *(2006.01)*     *G04B 17/04* *(2006.01)*
*H01L 41/04* *(2006.01)*    *H03H 9/17* *(2006.01)*
*H03H 9/21* *(2006.01)*     *G04C 3/12* *(2006.01)*

(54) **Résonateur thermocompensé par un métal à mémoire de forme**

Durch ein Metall mit Formgedächtnis thermokompensierter Resonator

Resonator thermocompensated by a shape-memory metal

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**13.08.2014  Bulletin 2014/33**

(73) Titulaire: **The Swatch Group Research and
Development Ltd.
2074 Marin (CH)**

(72) Inventeur: **Hessler, Thierry
2024 St-Aubin (CH)**

(74) Mandataire: **Couillard, Yann Luc Raymond et al
ICB
Ingénieurs Conseils en Brevets SA
Faubourg de l'Hôpital 3
2001 Neuchâtel (CH)**

(56) Documents cités:
**EP-A1- 2 395 661      CH-A2- 699 780
CH-A2- 701 770      JP-A- H 109 315
JP-A- 2003 065 213**

**Description**

Domaine de l'invention

L'invention se rapporte à un résonateur thermocompensé du type balancier-spiral ou diapason permettant de fabriquer une base de temps ou de fréquence dont les coefficients thermiques sont sensiblement nuls au premier ordre voire au deuxième ordre.

Arrière-plan de l'invention

Le document EP 1 422 436 divulgue un spiral formé en silicium et recouvert de dioxyde de silicium afin de rendre le coefficient thermique sensiblement nul autour des températures de procédure COSC, c'est-à-dire entre +8 et +38 °C. De même, le document WO 2008-043727 divulgue un résonateur MEMS qui possède des qualités similaires de faible dérive de son module d'Young dans la même plage de température. CH 699 780 A2 divulgue un ressort spiral formé en silicium qui comporte de la matière pour compenser au moins partiellement le premier CTE du silicium. La matière est ajoutée soit sous la forme d'un revêtement comprenant un métal ou un alliage et couvrant au moins partiellement la surface extérieure du ressort spiral soit à l'intérieur du ressort spiral. La matière ajoutée est un alliage de type Invar, Elinvar ou Kovar ou un alliage Fe-36%Ni. Cependant la dérive de la fréquence des divulgations ci-dessus peut nécessiter des corrections complexes selon les applications. Par exemple, pour que des montres électroniques à quartz puissent être certifiées COSC, une correction électronique basée sur une mesure de la température doit être effectuée.

Résumé de l'invention

Le but de la présente invention est de pallier tout ou partie les inconvénients cités précédemment en proposant un résonateur compensé thermiquement au moins au premier ordre.

A cet effet, l'invention se rapporte à un résonateur thermocompensé comportant un corps utilisé en déformation, l'âme du corps étant formée par un premier matériau **caractérisé en ce qu'a**u moins une partie du corps comporte au moins un revêtement en métal à mémoire de forme dont les variations du module d'Young en fonction de la température sont de signe opposé à celles du premier matériau utilisé pour l'âme afin de permettre audit résonateur d'avoir une variation de fréquence en fonction de la température au moins au premier ordre sensiblement nulle.

Avantageusement selon l'invention, le corps du résonateur utilisé en déformation peut comporter un seul revêtement pour compenser un ou deux ordres. Ainsi, suivant les grandeurs et les signes de chaque ordre du matériau de revêtement, le calcul de l'épaisseur du revêtement est effectué afin de compenser au moins le premier ordre.

Conformément à d'autres caractéristiques avantageuses de l'invention :

- l'âme du corps comporte du verre, du verre métallique, de la céramique technique, du verre céramique, du silicium monocristallin dopé ou non, du silicium polycristallin dopé ou non, ou du quartz ;
- ledit au moins un revêtement comporte un alliage à base de Cu-Zn, Co-Ni, Ni-Ti ou Cu-Al ;
- le corps comporte une section sensiblement en forme d'un quadrilatère dont les faces sont identiques deux à deux ;
- le corps comporte une section sensiblement en forme d'un quadrilatère dont les faces sont entièrement revêtues ;
- ledit au moins un revêtement forme une barrière contre l'humidité ;
- ledit au moins un revêtement est paramagnétique ou diamagnétique ;
- le corps (5) est un barreau enroulé sur lui-même en formant un spiral et est couplé avec un volant d'inertie ;
- le corps comporte au moins deux barreaux montés symétriquement afin de former un diapason.

Enfin, l'invention se rapporte également à une base de temps ou de fréquence, comme par exemple une pièce d'horlogerie, **caractérisée en ce qu'**elle comporte au moins un résonateur conforme à l'une des variantes précédentes.

Description sommaire des dessins

D'autres particularités et avantages ressortiront clairement de la description qui en est faite ci-après, à titre indicatif et nullement limitatif, en référence aux dessins annexés, dans lesquels :

- la figure 1 est une représentation en perspective d'une partie d'un résonateur balancier - spiral ;
- la figure 2 est une section représentative du ressort-spiral de la figure 1 ;
- les figures 3 et 4 sont des alternatives de sections d'un résonateur selon l'invention ;
- la figure 5 est une représentation générale en perspective d'un résonateur du type diapason ;
- les figures 6 et 7 sont des alternatives de sections d'un résonateur selon l'invention.

Description détaillée des modes de réalisation préférés

Comme expliqué ci-dessus, l'invention se rapporte à une pièce d'horlogerie comportant un résonateur qui peut être du type balancier-spiral ou diapason. Cependant, d'autres applications pour le résonateur seront réalisables pour un homme du métier sans difficultés excessives à partir de l'enseignement ci-dessous.

A titre de définition, la variation relative de la fréquence d'un résonateur suit la relation suivante :

$$\frac{\Delta f}{f_0} = A + \alpha \cdot (T - T_0) + \beta \cdot (T - T_0)^2 + \gamma \cdot (T - T_0)^3$$

où :

- $\frac{\Delta f}{f_0}$ est la variation relative de fréquence (ppm ou $10^{-6}$) ;
- $A$ une constante qui dépend du point de référence (ppm) ;
- $T_0$ la température de référence (°C) ;
- $\alpha$ le coefficient thermique du premier ordre (ppm.°C$^{-1}$) ;
- $\beta$ le coefficient thermique du deuxième ordre (ppm. °C$^{-2}$) ;
- $\gamma$ le coefficient thermique du troisième ordre (ppm. °C$^{-3}$).

De plus, le coefficient thermoélastique (*CTE*) représente la variation relative du module d'Young en fonction de la température. Les termes « $\alpha$ » et « $\beta$ » qui sont utilisés ci-dessous représentent ainsi respectivement les coefficients thermiques des premier et deuxième ordres, c'est-à-dire la variation relative de la fréquence du résonateur en fonction de la température. Les termes « $\alpha$ » et « $\beta$ » dépendent du coefficient thermoélastique du corps du résonateur et des coefficients de dilatation du corps. De plus, les termes « $\alpha$ » et « $\beta$ » prennent également en compte les coefficients propres à une éventuelle inertie séparée, telle que, par exemple, le balancier (formant un volant d'inertie) pour un résonateur balancier - spiral.

Les oscillations de tout résonateur destiné à une base de temps ou de fréquence devant être entretenues, la dépendance thermique comprend également une contribution éventuelle du système d'entretien.

Le paramètre le plus important est donc le coefficient thermoélastique (*CTE*) qu'il ne faut pas confondre avec l'abréviation anglaise CTE pour « Constant of Thermal Expansion » qui concerne le coefficient de dilatation.

Le coefficient thermoélastique (*CTE*) de la plupart des métaux est très négatif, de l'ordre de -1000 ppm.°C$^{-1}$. Il est par conséquent inimaginable de les utiliser pour réaliser un spiral. Des alliages complexes ont donc été développés, comme le Nivarox CT, afin de répondre à cette problématique. Ils restent toutefois difficiles à maîtriser notamment quant à leur fabrication.

Avantageusement, l'invention se rapporte à des matériaux alternatifs pour former lesdits résonateurs. L'invention se rapporte ainsi à un résonateur 1, 11 thermocompensé comportant un corps 5, 15 utilisé en déformation, l'âme 8, 18 du corps 5, 15 étant formée par un premier matériau comme une céramique, un matériau à base silicium ou un matériau à base de quartz.

Une céramique peut être considérée comme un article ayant un corps vitrifié ou non, de structure cristalline ou partiellement cristalline, ou de verre, dont le corps est formé de substances essentiellement inorganiques et métalliques ou non, et qui est formé par une masse en fusion qui se solidifie en se refroidissant, ou qui est formé et porté à maturité, en même temps ou ultérieurement, par l'action de la chaleur.

Une céramique selon l'invention englobe donc notamment des verres simples, des verres métalliques, des céramiques techniques comme le carbure de silicium ou des verres céramiques.

Un matériau à base de silicium peut être, par exemple, du silicium monocristallin, du silicium polycristallin, du silicium monocristallin dopé ou du silicium polycristallin dopé, lesquels peuvent comporter une couche d'oxyde native ou d'une couche d'épaisseur supérieure à l'oxyde natif. Enfin, le matériau à base de quartz est, préférentiellement, une silice naturelle ou synthétique qui est cristallisée sous forme trigonale du type *alpha* ou *beta*.

Avantageusement selon l'invention, au moins une partie du corps 5, 15 comporte au moins un revêtement 2, 4, 6, 12, 14, 16 en métal à mémoire de forme dont les variations du module d'Young en fonction de la température $CTE_1$ sont de signe opposé à celles $CTE_2$ du premier matériau utilisé pour l'âme 8, 18 afin de permettre audit résonateur d'avoir une variation de fréquence en fonction de la température au moins au premier ordre $\alpha$, $\beta$ sensiblement nulle.

Ledit au moins un revêtement 2, 4, 6, 12, 14, 16 en métal à mémoire de forme peut comporter, par exemple, un alliage à base de Ag-Cd, Au-Cd, Co-Ni, Cu-Al, Cu-Mn, Cu-Sn, Cu-Zn, Fe-Mn-Si, Fe-Ni, Fe-Pt, Ni-Ti, Ni-Mn ou Ti-Pd. Toutefois, ledit au moins un revêtement 2, 4, 6, 12, 14, 16 comporte, de manière préférée, un alliage à base de Cu-Zn, Co-Ni, Ni-Ti ou Cu-Al.

En effet, il est intéressant que le revêtement puisse être électriquement conducteur et peu sensible aux champs magnétiques afin d'éviter que déplacement parasite par rapport à la trajectoire prédéterminée du corps. De plus, Ces métaux à mémoire de forme sont avantageusement très stables chimiquement. A titre d'exemple, ils sont très résistants au nettoyage et insensibles à l'humidité ce qui en font une excellente barrière contre l'humidité.

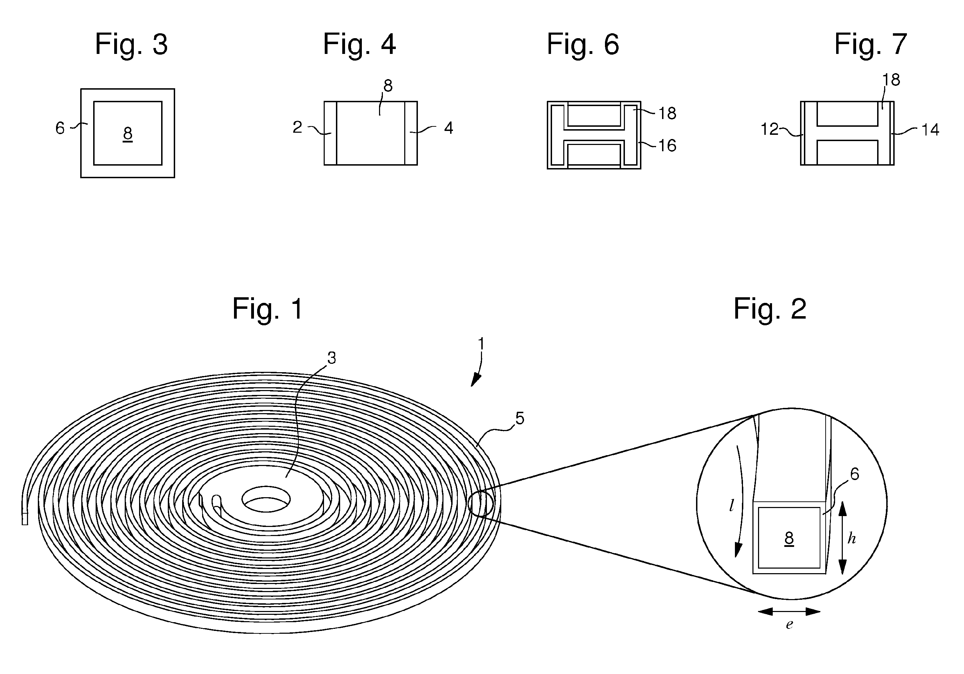

Dans un exemple illustré aux figures 1 et 2, on peut voir un spiral 1 dont le corps 5 est venu de forme avec sa virole 3 et dont les coefficients thermiques au premier ordre α voire au deuxième ordre β sont compensés par l'utilisation de deux matériaux pour respectivement l'âme 8 et le revêtement 6. La figure 2 propose une coupe du corps 5 du spiral 1 permettant de mieux voir sa section en forme de quadrilatère. Le corps 5 peut ainsi être défini par sa longueur *l*, sa hauteur *h* et son épaisseur *e*.

La figure 2 montre un exemple où l'âme 8 est entièrement revêtue. Bien évidemment, la figure 2 présente uniquement un exemple non limitatif. Ainsi, le spiral 1 peut comporter un revêtement 2, 4, 6 sur au moins une partie comme une ou plusieurs faces ou même la totalité de la surface extérieure du corps 5 comme les exemples illustrés aux figures 3 et 4. A titre informatif, les revêtements 2, 4, 6 ne sont pas à l'échelle par rapport aux dimensions de l'âme 8, ceci afin de mieux montrer les localisations de chaque partie.

On comprend donc que le corps selon l'invention peut comporter de manière non limitative une section sensiblement en forme d'un quadrilatère dont une seule face est revêtue ou dont les faces sont identiques deux à deux ou encore dont les faces sont entièrement revêtues de manière identique ou pas.

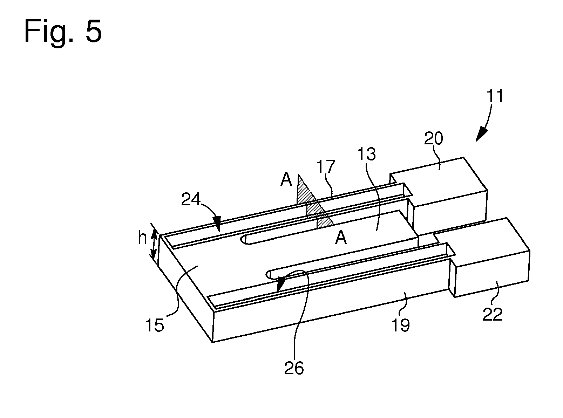

De manière similaire, avantageusement selon l'invention, on peut voir un résonateur 11 du type diapason à la figure 5. Le corps 15 du résonateur est formé d'une base 13 raccordée à deux bras 17, 19 destinés à osciller. A titre d'exemple, le diapason 11 utilisé est du type inversé, c'est-à-dire que la base 13 se prolonge entre les deux bras 17, 19, du type palmé, c'est-à-dire que les deux bras 17, 19 comportent à leur extrémité des palmes 20, 22 et du type rainuré (également connu sous le nom anglais « groove »), c'est-à-dire que les deux bras 17, 19 comportent des rainures 24, 26. On comprend toutefois qu'il existe une multitude de variantes possibles de diapasons qui peuvent, de manière non exhaustive, être du type inversé et/ou du type rainuré et/ou du type conique et/ou du type palmé.

Le diapason 11, avantageusement selon l'invention, comporte des coefficients thermiques au premier ordre α voire au deuxième ordre β qui sont compensés par le dépôt d'une couche 12, 14, 16 contre l'âme 18 du corps 15. Les figures 6 et 7 proposent deux exemples non exhaustifs de coupe du corps 15 du diapason 11 selon le plan A-A. Les sections en forme de quadrilatère rainuré montrent l'âme 18 du corps 15 recouvert d'au moins un revêtement 12, 14, 16 sur au moins une partie comme une ou plusieurs faces ou même la totalité de la surface extérieure du corps 15. Comme pour le premier exemple, les revêtements 12, 14, 16 ne sont pas à l'échelle par rapport aux dimensions de l'âme 18, ceci afin de mieux montrer les localisations de chaque partie.

L'âme 8, 18 du résonateur 1, 11 peut être formée par une céramique, un matériau à base silicium ou un matériau à base de quartz. Toutefois, cela implique une grande variété de matériau. C'est pourquoi, des matériauxqui possèdent de faibles coefficients thermoélastiques (*CTE*) et de dilatation ($\alpha_{spi}$) sont préférés.

Il est ainsi possible d'utiliser aussi bien du verre de quartz également appelé quartz fondu (en anglais « fused quartz ») que du quartz cristallisé.

Suivant la méthode de fabrication du premier matériau, la valeur du coefficient thermoélastique (*CTE*) obtenue est généralement faible et positive ou négative, c'est-à-dire comprise entre 100 et 500 ppm. °C$^{-1}$.

Par conséquent, le revêtement 2, 4, 6, 12, 14, 16 comporte un coefficient thermoélastique (*CTE*) qui est négatif ou positif. Comme expliqué ci-dessus, le tel revêtement peut donc comporter un alliage métallique à mémoire de forme comme préférentiellement un alliage à base de Cu-Zn, Co-Ni, Ni-Ti ou Cu-Al. A titre d'exemple, l'âme 8, 18 en silicium monocristallin d'un résonateur 1, 11 selon l'invention peut ainsi être compensé thermique à l'aide d'un revêtement 2, 4, 6, 12, 14, 16 à base de Ni-Ti de l'ordre du micromètre qui comporte un coefficient thermoélastique (*CTE*) qui est positif.

Comme expliqué ci-dessus, on comprend que le premier matériau peut comporter un coefficient thermoélastique (*CTE*) aux premier ordre et deuxième ordres qui peuvent être aussi bien positifs que négatifs. C'est pourquoi le ou les revêtements 2, 4, 6, 12, 14, 16, utilisés pour l'âme 8, 18 peuvent incidemment comporter des coefficients thermoélastiques (*CTE*) au premier ordre et au deuxième ordre aussi bien négatifs que positifs.

Préférentiellement, le dépôt du revêtement 2, 4, 6, 12, 14, 16, en métal à mémoire de forme est du type à pulvérisation cathodique (également connu sous le mot anglais « sputtering »). A titre optionnel, une couche d'accrochage comme du chrome peut également être déposée préalablement au revêtement principal 2, 4, 6, 12, 14, 16 pour améliorer l'adhérence et/ou la perméabilité dudit revêtement.

## Revendications

**1.** Résonateur (1, 11) thermocompensé comportant un corps (5, 15) utilisé en déformation, l'âme (8, 18) du corps (5, 15) étant formée par un premier matériau **caractérisé en ce qu'a**u moins une partie du corps (5, 15) comporte au moins un revêtement (2, 4, 6, 12, 14, 16) en métal à mémoire de forme dont les variations du module d'Young en fonction de la température, *CTE,* sont de signe opposé à celles, *CTE,* du premier matériau utilisé pour l'âme (8, 18) afin de permettre audit résonateur d'avoir une variation de fréquence en fonction de la température au moins au premier ordre, *α,β,* sensiblement nulle.

2. Résonateur (1, 11) selon la revendication précédente, **caractérisé en ce que** l'âme (8, 18) du corps (5, 15) comporte du verre, du verre métallique, de la céramique technique ou du verre céramique.

3. Résonateur (1, 11) selon la revendication 1, **caractérisé en ce que** l'âme (8, 18) du corps (5, 15) comporte du silicium monocristallin dopé ou non, ou du silicium polycristallin dopé ou non.

4. Résonateur (1, 11) selon la revendication 1, **caractérisé en ce que** l'âme (8, 18) du corps (5, 15) comporte du quartz.

5. Résonateur (1, 11) selon l'une des revendications précédentes, **caractérisé en ce que** ledit au moins un revêtement (2, 4, 6, 12, 14, 16) comporte un alliage à base de Cu-Zn, Co-Ni, Ni-Ti ou Cu-Al.

6. Résonateur (1, 11) selon l'une des revendications précédentes, **caractérisé en ce que** le corps (5, 15) comporte une section sensiblement en forme d'un quadrilatère dont les faces sont identiques deux à deux.

7. Résonateur (1, 11) selon l'une des revendications 1 à 5, **caractérisé en ce que** le corps (5, 15) comporte une section sensiblement en forme d'un quadrilatère dont les faces sont entièrement revêtues.

8. Résonateur (1, 11) selon l'une des revendications précédentes, **caractérisé en ce que** ledit au moins un revêtement (2, 4, 6, 12, 14, 16) forme une barrière contre l'humidité.

9. Résonateur (1, 11) selon l'une des revendications précédentes, **caractérisé en ce que** ledit au moins un revêtement (2, 4, 6, 12, 14, 16) est paramagnétique ou diamagnétique.

10. Résonateur (1) selon l'une des revendications précédentes, **caractérisé en ce que** le corps (5) est un barreau enroulé sur lui-même en formant un spiral et est couplé avec un volant d'inertie.

11. Résonateur (11) selon l'une des revendications 1 à 9, **caractérisé en ce que** le corps (15) comporte au moins deux barreaux (17, 19) montés symétriquement afin de former un diapason.

12. Pièce d'horlogerie **caractérisée en ce qu'**elle comporte au moins un résonateur (1, 11) conforme à l'une des revendications précédentes.

**Patentansprüche**

1. Thermokompensierter Resonator (1, 11), der einen Körper (5, 15) umfasst, der mit Verformbarkeit verwendet wird, wobei der Kern (8, 18) des Körpers (5, 15) aus einem ersten Material gebildet ist, **dadurch gekennzeichnet, dass** wenigstens ein Teil des Körpers (5, 15) wenigstens eine Beschichtung (2, 4, 6, 12, 14, 16) aus einem Formerinnerungsmetall aufweist, dessen Änderungen des Young-Moduls als Funktion der Temperatur, CTE, ein Vorzeichen haben, das zu jenen, CTE, des für den Kern (8, 18) verwendeten ersten Materials entgegen-gesetzt ist, um dem Resonator zu ermöglichen, dass seine Frequenzänderung als Funktion der Temperatur wenigstens erster Ordnung, α, β, im Wesentlichen null ist.

2. Resonator (1, 11) nach dem vorhergehenden Anspruch, **dadurch gekennzeichnet, dass** der Kern (8, 18) des Körpers (5, 15) Glas, Metallglas, technische Keramik oder keramisches Glas enthält.

3. Resonator (1, 11) nach Anspruch 1, **dadurch gekennzeichnet, dass** der Kern (8, 18) des Körpers (5, 15) dotiertes oder nicht dotiertes monokristallines Silicium oder dotiertes oder nicht dotiertes polykristallines Silicium enthält.

4. Resonator (1, 11) nach Anspruch 1, **dadurch gekennzeichnet, dass** der Kern (8, 18) des Körpers (5, 15) Quarz enthält.

5. Resonator (1, 11) nach einem der vorhergehenden Ansprüche, **dadurch gekennzeichnet, dass** die wenigstens eine Beschichtung (2, 4, 6, 12, 14, 16) eine Legierung auf Cu-Zn-, Co-Ni-, Ni-Ti- oder Cu-Al-Basis enthält.

**6.** Resonator (1, 11) nach einem der vorhergehenden Ansprüche, **dadurch gekennzeichnet, dass** der Körper (5, 15) einen im Wesentlichen vierseitigen Querschnitt aufweist, dessen Flächen paarweise gleich sind.

**7.** Resonator (1, 11) nach einem der Ansprüche 1 bis 5, **dadurch gekennzeichnet, dass** der Körper (5, 15) einen im Wesentlichen viereckigen Querschnitt aufweist, dessen Flächen vollständig beschichtet sind.

**8.** Resonator (1, 11) nach einem der vorhergehenden Ansprüche, **dadurch gekennzeichnet, dass** wenigstens eine Beschichtung (2, 4, 6, 12, 14, 16) eine Feuchtigkeitssperre bildet.

**9.** Resonator (1, 11) nach einem der vorhergehenden Ansprüche, **dadurch gekennzeichnet, dass** wenigstens eine Beschichtung (2, 4, 6, 12, 14, 16) paramagnetisch oder diamagnetisch ist.

**10.** Resonator (1) nach einem der vorhergehenden Ansprüche, **dadurch gekennzeichnet, dass** der Körper (5) ein auf sich selbst gewickelter Stab ist, der eine Spirale bildet, und mit einem Schwungrad gekoppelt ist.

**11.** Resonator (11) nach einem der Ansprüche 1 bis 9, **dadurch gekennzeichnet, dass** der Körper (15) wenigstens zwei Stäbe (17, 19) aufweist, die symmetrisch montiert sind, um eine Stimmgabel zu bilden.

**12.** Zeitmessgerät, **dadurch gekennzeichnet, dass** es wenigstens einen Resonator (1, 11) nach einem der vorhergehenden Ansprüche umfasst.


**Claims**

**1.** Thermocompensated resonator (1, 11) comprising a body (5, 15) used in deformation, the core (8, 18) of the body (5, 15) being formed by a first material, **characterised in that** at least one part of the body (5, 15) comprises at least one coating (2, 4, 6, 12, 14, 16) made of shape-memory metal, the variations in the Young's modulus of which as a function of the temperature $CTE$ are of opposite sign to those $CTE$ of the first material used for the core (8, 18) so as to allow said resonator to have a frequency variation as a function of the temperature which is substantially zero at least to the first order $\alpha$, $\beta$.

**2.** Resonator (1, 11) according to the preceding claim, **characterised in that** the core (8, 18) of the body (5, 15) comprises glass, metallic glass, technical ceramic or ceramic glass.

**3.** Resonator (1, 11) according to claim 1, **characterised in that** the core (8, 18) of the body (5, 15) comprises monocrystalline silicon which is doped or not, or polycrystalline silicon which is doped or not.

**4.** Resonator (1, 11) according to claim 1, **characterised in that** the core (8, 18) of the body (5, 15) comprises quartz.

**5.** Resonator (1, 11) according to any of the preceding claims, **characterised in that** said at least one coating (2, 4, 6, 12, 14, 16) comprises an alloy based on Cu-Zn, Co-Ni, Ni-Ti or Cu-Al.

**6.** Resonator (1, 11) according to any of the preceding claims, **characterised in that** the body (5, 15) comprises a section substantially in the shape of a quadrilateral, the faces of which are identical in pairs.

**7.** Resonator (1, 11) according to one of the claims 1 to 5, **characterised in that** the body (5, 15) comprises a section which is substantially in the shape of a quadrilateral, the faces of which are completely coated.

**8.** Resonator (1, 11) according to any of the preceding claims, **characterised in that** said at least one coating (2, 4, 6, 12, 14, 16) forms a barrier against humidity.

**9.** Resonator (1, 11) according to any of the preceding claims, **characterised in that** said at least one coating (2, 4, 6, 12, 14, 16) is paramagnetic or diamagnetic.

**10.** Resonator (1) according to any of the preceding claims, **characterised in that** the body (5) is a bar which is coiled on itself forming a balance spring and is coupled to a flywheel.

**11.** Resonator (11) according to any of the claims 1 to 9, **characterised in that** the body (15) comprises at least two bars (17, 19) which are mounted symmetrically so as to form a tuning fork.

12. Timepiece, **characterised in that** it comprises at least one resonator (1, 11) according to any of the preceding claims.

Fig. 3

Fig. 4

Fig. 6

Fig. 7

Fig. 1

Fig. 2

EP 2 765 705 B1

Fig. 5

**RÉFÉRENCES CITÉES DANS LA DESCRIPTION**

**Documents brevets cités dans la description**

- EP 1422436 A
- WO 2008043727 A
- CH 699780 A2